(19) **Europäisches Patentamt European Patent Office Office européen des brevets**

(11) **EP 3 138 050 B1**

(12) **FASCICULE DE BREVET EUROPEEN**

(45) Date de publication et mention de la délivrance du brevet:
**05.05.2021 Bulletin 2021/18**

(21) Numéro de dépôt: **15718863.2**

(22) Date de dépôt: **24.04.2015**

(51) Int Cl.:
*G06N 3/063* (2006.01)     *G06N 3/04* (2006.01)
*G11C 11/54* (2006.01)     *G11C 13/00* (2006.01)

(86) Numéro de dépôt international:
**PCT/EP2015/058873**

(87) Numéro de publication internationale:
**WO 2015/165809 (05.11.2015 Gazette 2015/44)**

(54) **NEURONE ARTIFICIEL MONO-COMPOSANT À BASE D'ISOLANTS DE MOTT, RÉSEAU DE NEURONES ARTIFICIELS ET PROCÉDÉ DE FABRICATION CORRESPONDANTS**

AUS MOTT-ISOLATOREN HERGESTELLTES, EINKOMPONENTIGES KÜNSTLICHES NEURON, NETZ AUS KÜNSTLICHEN NEURONEN UND VERFAHREN ZUR HERSTELLUNG DER BESAGTEN KÜNSTLICHEN NEURONEN

SINGLE-COMPONENT ARTIFICIAL NEURON MADE FROM MOTT INSULATORS, NETWORK OF ARTIFICIAL NEURONS, AND METHOD FOR MAKING SAID ARTIFICIAL NEURONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.04.2014 FR 1453834**

(43) Date de publication de la demande:
**08.03.2017 Bulletin 2017/10**

(73) Titulaires:
• **Centre National de la Recherche Scientifique (C.N.R.S.)**
  **75794 Paris Cedex 16 (FR)**
• **Université de Nantes**
  **44035 Nantes Cedex 1 (FR)**
• **Université Paris-Saclay**
  **91190 Saint-Aubin (FR)**

(72) Inventeurs:
• **CARIO, Laurent**
  **F-44200 Nantes (FR)**
• **CORRAZE, Benoit**
  **F-44470 Carquefou (FR)**
• **STOLIAR, Pablo**
  **Tsukuba 305-8565 (JP)**
• **TRANCHANT, Julien**
  **F-44000 Reze (FR)**
• **JANOD, Etienne**
  **F-44240 La Chapelle sur Erdre (FR)**

• **BESLAND, Marie-Paule**
  **F-44700 Orvault (FR)**
• **ROZENBERG, Marcelo**
  **F-75013 Paris (FR)**

(74) Mandataire: **Lavoix**
  **2, place d'Estienne d'Orves**
  **75441 Paris Cedex 09 (FR)**

(56) Documents cités:
• **M. J. Rozenberg: "Universal dielectric breakdown and synaptic behavior in Mott insulators", Abstracts of the Conference on Ultrafast Dynamics of Correlated Materials, 14 octobre 2013 (2013-10-14), XP055160890, Extrait de l'Internet: URL:http://indico.ictp.it/event/a12215/ses sion/25/contribution/17/material/0/0.pdf [extrait le 2014-05-05]**
• **M. D. PICKETT ET AL: "A scalable neuristor built with Mott memristors", NATURE MATERIALS, vol. 12, no. 2, 16 décembre 2012 (2012-12-16), pages 114-117, XP055110620, DOI: 10.1038/nmat3510**
• **Technology working group on emerging research devices: "Emerging research devices", 2013 Edition of the International Technology Roadmap for Semiconductors, 2013, XP055160881, Extrait de l'Internet: URL:http://www.itrs.net/Links/2013ITRS/201 3Chapters/2013ERD.pdf [extrait le 2014-03-04]**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**(Cont. page suivante)**

EP 3 138 050 B1

- **A. L. PERGAMENT ET AL: "Oxide electronics and vanadium dioxide perspective: a review", JOURNAL ON SELECTED TOPICS IN NANO ELECTRONICS AND COMPUTING, vol. 1, no. 1, 15 décembre 2013 (2013-12-15), pages 24-43, XP055161096, DOI: 10.15393/j8.art.2013.3002**
- **A. Crunteanu-Stanescu: "Chapitre 3: conclusions et perspectives", Conception et développement de dispositifs et matériaux innovants pour la microélectronique et l'optique, 4 avril 2014 (2014-04-04), pages 174-184, XP055161101, Extrait de l'Internet: URL:http://tel.archives-ouvertes.fr/tel-01 054499 [extrait le 2014-08-07]**

**Description**

## 1. DOMAINE DE L'INVENTION

Le domaine de l'invention est celui des circuits électroniques neuromorphiques, et plus particulièrement celui des neurones artificiels.

Les réseaux de neurones artificiels sont inspirés des réseaux de neurones biologiques dont ils imitent le fonctionnement.

Plus précisément, l'invention concerne une nouvelle conception d'un neurone artificiel.

L'invention présente des applications notamment, mais non exclusivement, dans le domaine de l'intelligence artificielle, et plus particulièrement, dans le domaine des mémoires associatives, des méthodes de reconnaissance d'images et de sons, ou encore dans le domaine des méthodes d'apprentissage ou d'auto-apprentissage mises en œuvre par des réseaux de neurones artificiels. Par exemple, ces méthodes d'apprentissage permettent l'extraction de connaissances organisées à partir de données réelles ou simulées selon le principe suivant : les données considérées comme similaires sont regroupées dans un même groupe alors que les données considérées comme différentes sont réparties dans des groupes distincts.

## 2. ARRIÈRE-PLAN TECHNOLOGIQUE

Depuis un demi-siècle, la révolution des technologies de l'information est étroitement associée au développement de l'ordinateur. Or, tous les ordinateurs sont construits selon une architecture dite de Von Neumann. Cette architecture, selon laquelle l'unité de traitement (CPU) et les mémoires constituent des blocs séparés, est extrêmement efficace pour certaines tâches, telles que le traitement ultra-rapide des flux de données volumineux.

Cependant, cette architecture est peu efficace dans de nombreux contextes et les ordinateurs restent dépassés dans plusieurs grandes classes de problèmes par le cerveau humain, qui fonctionne sur une architecture très différente, basée sur un réseau entremêlé de neurones et de synapses biologiques.

Pour dépasser ces limitations inhérentes à l'architecture de Von Neumann, une voie prometteuse consiste donc à développer une architecture électronique de type neuromorphique, constituée de neurones et synapses artificiels imitant l'architecture du cerveau humain. Pour l'essentiel, le cerveau humain est constitué d'un réseau de $10^{11}$ neurones reliés entre eux par $10^{15}$ synapses. Les données sont stockées dans la mémoire du cerveau humain grâce aux différents niveaux de conductance des synapses, communément appelés poids synaptiques. Par conséquent, la réalisation d'un cerveau artificiel passe par la réalisation de réseaux neuronaux artificiels qui imitent l'interconnexion des neurones via les synapses.

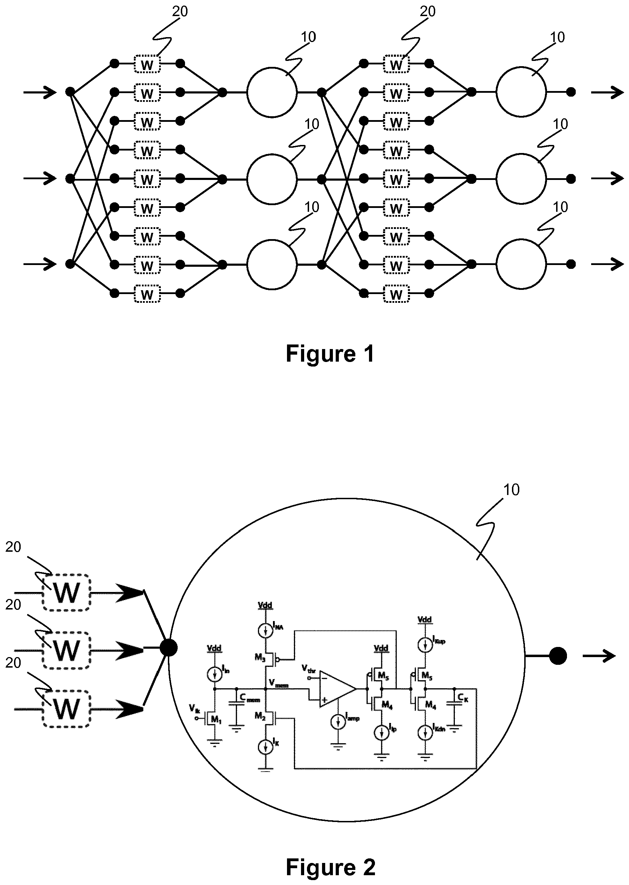

Les réseaux de neurones artificiels sont composés essentiellement de neurones interconnectés entre eux par des synapses. La **figure 1** par exemple présente une architecture neuromorphique, dite de perceptron multicouche, composée de six neurones (référencés 10) et dix-huit synapses (référencées 20). Le poids synaptique est représenté par la lettre w.

Alors que la micro-électronique basée sur l'architecture de Von Neumann atteint des limites physiques quant à la miniaturisation des composants électroniques, ces architectures neuromorphiques suscitent un très fort espoir pour les chercheurs et industriels, notamment en ce qui concerne l'efficacité énergétique.

On connaît, dans l'état de la technique, différents types de réseaux de neurones artificiels.

Dans la plupart des cas, ces réseaux neuronaux sont « virtuels », c'est-à-dire implémentés par des programmes d'ordinateur (appelés *"Software Neural Networks"* en anglais) utilisant des ordinateurs à architecture conventionnelle, ce qui diminue leur efficacité, notamment en termes de consommation en énergie.

Récemment, les architectures neuromorphiques « matérielles », c'est-à-dire à base de réseaux de neurones matériels (appelées *"Hardware Neural Networks"* en anglais), sont apparues comme des solutions alternatives prometteuses, dans lesquelles chaque neurone et chaque synapse est constitué de composants électroniques classiques. Or la réalisation actuelle de ces neurones artificiels et synapses artificielles nécessite l'utilisation de circuits électroniques relativement complexes et énergivores.

Par exemple, l'implémentation classique d'une synapse artificielle requiert l'utilisation d'un grand nombre de composants, dont plus d'une dizaine de transistors. Récemment la découverte des memristors (dipôles dont la résistance électrique dépend de l'historique du signal électrique qui les a traversés) a apporté un saut conceptuel important dans le domaine des synapses artificielles.

En comparaison, le domaine des neurones artificiels a beaucoup moins progressé. Un exemple de réalisation d'un neurone artificiel multi-composants 10 selon l'état de la technique est illustré à la **figure 2.** Ce neurone 10 nécessite l'implantation, sur un circuit imprimé, d'un nombre important de composants électroniques tels que des transistors (par exemple en technologie CMOS), des amplificateurs et des condensateurs, composants agencés selon une architecture relativement complexe. L'implantation de différents composants est une opération relativement complexe, de nombreux composants devant être mis en place sur une surface de plus en plus restreinte, du fait des exigences de miniaturisation. En outre, malgré la réduction de la taille des composants électroniques, l'ensemble occupe toujours une certaine surface, qu'il est difficile de réduire. De plus, une telle complexité nuit fortement aux performances globales du circuit électronique, en termes d'intégration et d'efficacité énergétique.

Cette complexité s'explique par le fait qu'un neurone artificiel doit réaliser plusieurs fonctions. Tout d'abord, un neurone artificiel impulsionnel (*« spiking neuron »* en anglais) doit réagir à l'application de trains d'impulsions électriques. En effet, c'est sous cette forme d'impulsions (*« spikes »*) que l'information circule dans les réseaux neuronaux artificiels les plus prometteurs.

De plus, un neurone artificiel doit idéalement reproduire un comportement similaire à celui décrit par le modèle standard LIF (pour *« Leaky, Integrate and Fire »*), c'est-à-dire un comportement mettant en œuvre les trois fonctions suivantes : intégration, fuite et tir.

Le principe du modèle LIF se fonde sur une description simplifiée du comportement d'un neurone biologique, centrée sur la charge électrique accumulée au travers de la membrane pré-synaptique. Il modélise cette membrane par une capacité C et une résistance de fuite R en parallèle. Lorsqu'un neurone artificiel reçoit un signal électrique d'entrée S(t), le modèle LIF prévoit :

> (i) que le neurone artificiel intègre (*« Integrate »*) temporellement une fonction de ce signal d'entrée ;
> (ii) que la quantité correspondant au résultat de cette intégration par le neurone artificiel se relaxe au cours du temps (*« Leaky »).* Le signal électrique *v(t)*, qui résulte des deux phénomènes intègre et fuite, est l'équivalent du potentiel de membrane pré synaptique pour un neurone biologique ;
> (iii) que le neurone artificiel déclenche un signal en sortie (*« Fire »*) lorsque le signal électrique v(t) atteint un seuil donné.

Ce modèle peut être mathématiquement résumé par l'équation suivante :

$$\frac{\partial}{\partial t} v(t) = -v(t)\frac{1}{RC} + \frac{w}{C} S(t) \quad \text{équation (1)}$$

où :

> *v(t)* représente le signal électrique après intégration par le neurone artificiel ;
> *RC* représente le temps caractéristique de la relaxation exponentielle du signal intégré ; w représente le poids synaptique ;
> S(t) est une fonction représentant l'information (i.e. les impulsions électriques) arrivant à l'entrée du neurone artificiel pondérée par le poids synaptique w.

Le modèle LIF postule qu'il existe un seuil unique pour *v(t)*, indépendant de la forme du signal d'entrée, au-delà duquel le neurone artificiel LIF déclenche la fonction « tir ». Dans le cas où le signal électrique d'entrée *S(t)* est une séquence d'impulsions électriques carrées de même amplitude, le développement mathématique du modèle LIF permet d'établir la relation théorique suivante :

$$N_{Fire} = -\frac{\tau}{t_{off}} \ln \left\{ 1 - \frac{\tau}{t_{on}} \times \left[ 1 - exp\left(\frac{-t_{off}}{\tau}\right) \right] \times \left[ 1 - exp\left(\frac{-t_{Fire}}{\tau}\right) \right] \right\} \quad \text{équation (2)}$$

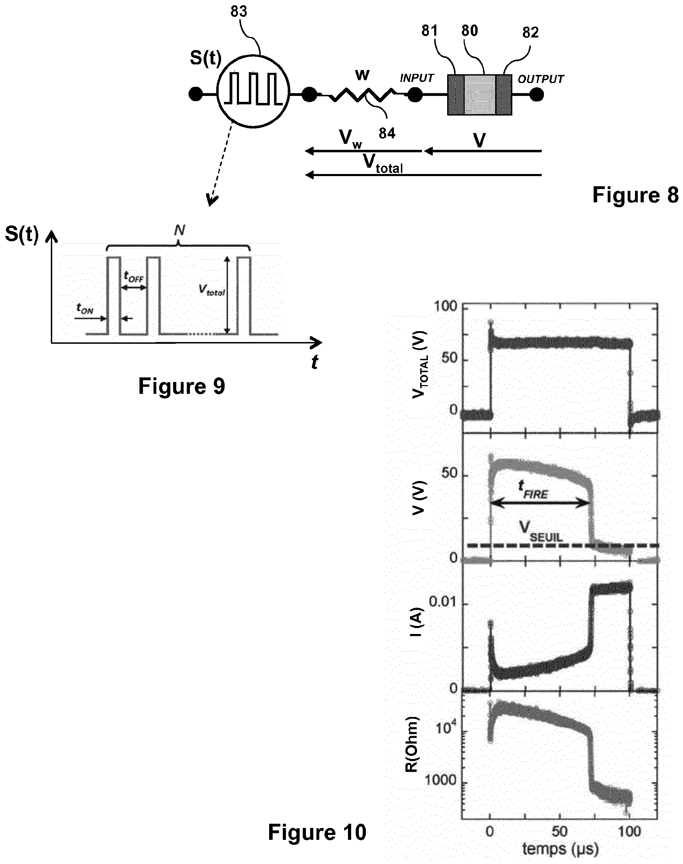

où $N_{Fire}$ représente le nombre d'impulsions électriques nécessaires pour déclencher la fonction « tir » ; $t_{on}$ la durée d'application de chaque impulsion électrique ; $t_{off}$ la durée s'écoulant entre deux impulsions électriques successives (voir figure 9) ; $t_{Fire}$ le temps nécessaire pour déclencher la fonction « tir » dans le cas où le signal électrique d'entrée est constitué d'une unique impulsion constante d'une durée supérieure à $t_{Fire}$ (voir figure 10) et $\tau = RC$ le temps caractéristique de la relaxation (voir équation (1)).

On connaît, dans l'état de la technique, la demande de brevet US 2014/0035614 (Matthew D. Pickett) qui propose une implémentation d'un neurone artificiel de type « Hodgkin-Huxley » au moyen d'un circuit électronique désigné sous le terme de *« neuristor »*. Or un tel circuit utilise un certain nombre de composants électroniques comme des résistances, des condensateurs et des memristors, et est donc construit dans le même esprit que les neurones artificiels conventionnels à base de transistors CMOS, discutés plus haut. Ce type de neurone reste donc complexe à mettre en œuvre et les performances en termes d'intégration sont limitées. De plus, ce type de neurone est focalisé sur la génération d'un potentiel d'action et ne met pas en œuvre les trois fonctions principales du modèle LIF, à savoir

4

l'intégration, la fuite et le tir.

Dans ce contexte, il serait particulièrement intéressant de pouvoir simplifier la réalisation de neurones artificiels et de réseaux neuronaux artificiels.

M. D. PICKETT ET AL: "A scalable neuristor built with Mott memristors",NATURE MATERIALS, vol. 12, no. 2, 16 décembre 2012 (2012-12-16), pages 114-117 porte sur un circuit electronique designe sous le terme de « neurositor » dont le comportement s'apparente a celui d'un neurone de type « Hodgkin-Huxley ». Ce circuit neuristor comprend des composants memristifs ainsi qued'autres composants electroniques elementaires classiques.

## 3. OBJECTIFS DE L'INVENTION

L'invention, dans au moins un mode de réalisation, a notamment pour objectif de pallier ces différents inconvénients de l'état de la technique.

Plus précisément, dans au moins un mode de réalisation de l'invention, un objectif est de proposer un neurone artificiel de conception nouvelle, qui soit simple à réaliser.

Au moins un mode de réalisation de l'invention a également pour objectif de proposer un neurone artificiel qui offre une forte potentialité d'intégration dans les circuits électroniques.

## 4. EXPOSÉ DE L'INVENTION

L'invention propose un neurone artificiel selon la revendication indépendante 1. On entend par dipôle électrique, un composant électronique possédant deux bornes.

Dans le cadre d'expérimentations réalisées sur des isolants de Mott présentant le phénomène de transition résistive volatile induite par impulsion électrique, les inventeurs ont découvert une nouvelle propriété de cette famille de matériaux qui permet de mettre en œuvre un neurone artificiel d'une manière bien plus simple que dans l'art antérieur. En effet, contrairement aux neurones artificiels de l'art antérieur qui requièrent une implémentation de circuits électroniques complexes, le neurone artificiel mono-composant selon l'invention est constitué d'un unique dipôle électrique, lui-même constitué d'un matériau isolant de Mott compris entre deux électrodes électriques. Lorsque ce dipôle est soumis à une succession d'impulsions électriques (représentatives d'informations provenant des synapses), celui-ci réalise les trois fonctions élémentaires d'un neurone artificiel tel que décrit dans le modèle de référence LIF, à savoir l'intégration avec fuite et le tir.

Cette solution permettant de mettre en œuvre un seul composant élémentaire remplissant l'ensemble des fonctionnalités d'un neurone artificiel est d'autant plus surprenante que, pour l'homme du métier, les solutions de l'art antérieur proposent des circuits complexes à base de divers composants électroniques. Les solutions proposées par l'art antérieur détourneraient donc l'homme du métier de la démarche à suivre pour parvenir à l'invention, celle-ci allant à l'encontre de ce qui a été précédemment établi.

Par ailleurs, du fait qu'il ne met en œuvre qu'un seul dipôle électrique, le neurone artificiel mono-composant selon l'invention nécessite peu d'énergie et présente une forte potentialité d'intégration dans les circuits électroniques.

Selon un aspect particulier de l'invention, le neurone artificiel comprend une entrée et une sortie. Le neurone artificiel est tel qu'une première extrémité du dipôle électrique comprend une première électrode électrique qui constitue ladite entrée et qu'une seconde extrémité du dipôle électrique comprend une seconde électrode électrique qui constitue ladite sortie du neurone artificiel.

Selon un aspect particulier de l'invention, les première et seconde électrodes électriques sont constituées d'un matériau électriquement conducteur appartenant au groupe comprenant :

- au moins l'un des éléments suivants: Platine (Pt), Or (Au), Molybdène (Mo), Graphite (C), Aluminium (Al), Cuivre (Cu), Silicium (Si) dopé;
- au moins l'un des alliages suivants : Laiton (Cu-Zn), Acier (Fe-C), Bronze (Cu-Sn);
- au moins l'un des composés de métaux de transition suivants: $TiN$, $TaN$, $RuO_2$, $SrRuO_3$, $CuS_2$).

A noter que cette liste n'est pas exhaustive.

Selon un aspect particulier de l'invention, ledit matériau appartient au groupe comprenant :

- des composés de formule $AM_4Q_8$, avec A qui comprend l'un au moins des éléments suivants : Ga, Ge, Zn ; M qui comprend l'un au moins des éléments suivants : V, Nb, Ta, Mo et Q qui comprend l'un au moins des éléments suivants : S, Se, Te ;
- des composés de formule $(V_{1-x}M_x)_2O_3$, avec $0 \leq x \leq 1$, M comprenant l'un au moins des éléments suivants : Ti, Cr, Fe, Al, ou Ga ;
- des composés de formule $NiS_{2-x}Se_x$, avec $0 \leq x \leq 1$.

- le composé de formule $VO_2$.
- des composés isolants de Mott organiques.

A noter que cette liste n'est pas exhaustive.

Selon une caractéristique particulièrement avantageuse de l'invention, ledit matériau se présente sous la forme :

- d'un bloc de cristal à base d'un isolant de Mott ; ou
- d'au moins une couche mince à base d'un isolant de Mott ; ou
- d'un nanotube à base d'un isolant de Mott ; ou
- d'un nanofil à base d'un isolant de Mott.

Ainsi, la structure du neurone artificiel peut être déclinée suivant plusieurs modes de réalisation particuliers.

Ainsi, dans le premier cas (matériau sous la forme d'un bloc de cristal), la structure du neurone artificiel peut être assimilée à une structure tridimensionnelle.

Ainsi, dans le deuxième cas (matériau sous la forme d'une couche mince), la structure du neurone artificiel peut être assimilée à une structure bidimensionnelle.

Ainsi, dans les troisième et quatrième cas (matériau sous la forme d'un nano-tube ou d'un nano-fil), la structure du neurone artificiel peut être assimilée à une structure unidimensionnelle.

Dans un autre mode de réalisation de l'invention, il est proposé un réseau de neurones selon la revendication indépendante 5.

L'invention permet de simplifier drastiquement la réalisation de réseaux neuronaux artificiels. Dans un mode de réalisation particulier, on peut envisager un réseau de neurones artificiels dont certains sont des neurones selon l'invention et d'autres sont des neurones de l'état de l'art. Dans un autre mode de réalisation, préférentiel cette-fois-ci, chaque neurone artificiel du réseau est un neurone artificiel mono-composant selon l'invention.

Dans un autre mode de réalisation de l'invention, il est proposé un circuit électronique neuromorphique selon la revendication indépendante 6.

Dans un autre mode de réalisation de l'invention, il est proposé un procédé de fabrication d'un neurone artificiel selon la revendication indépendante 7.

Le neurone artificiel mono-composant obtenu selon l'invention est donc d'une grande simplicité de fabrication. A noter que l'étape de dépôt des électrodes électriques peut être réalisée soit avant, soit après que l'isolant de Mott a été déposé.

Selon une réalisation particulière, ladite étape d'obtention d'un matériau comprend une étape de découpe d'un bloc de cristal appartenant à la famille des isolants de Mott et ladite étape de dépôt d'une couche de matériau conducteur est effectuée en fonction dudit bloc de cristal découpé.

Selon une variante de réalisation, ladite étape d'obtention d'un matériau comprend une étape de dépôt, sur une plaque de substrat, d'une couche mince à base d'un matériau appartenant à la famille des isolants de Mott, ladite étape de dépôt d'une couche de matériau conducteur au niveau des première et seconde extrémités étant effectuée en fonction de ladite couche mince déposée.

Selon une autre variante de réalisation, ladite étape d'obtention d'un matériau comprend une étape de dépôt, sur une plaque de substrat, d'un nanotube ou d'un nanofil à base d'un matériau appartenant à la famille des isolants de Mott, ladite étape de dépôt d'une couche de matériau conducteur au niveau des première et seconde extrémités étant effectuée en fonction dudit nanotube ou nanofil déposé.

## 5. LISTE DES FIGURES

D'autres caractéristiques et avantages de l'invention apparaîtront à la lecture de la description suivante, donnée à titre d'exemple indicatif et non limitatif, et des dessins annexés, dans lesquels :

- la figure 1, déjà décrite en relation avec l'art antérieur, présente un exemple d'architecture neuromorphique composée de neurones artificiels (illustrés par des cercles) connectés entre eux par des synapses artificielles (illustrés par des rectangles) ;
- la figure 2, déjà décrite en relation avec l'art antérieur, présente un schéma électronique d'un neurone artificiel de l'état de la technique ;
- la figure 3 présente la structure d'un neurone artificiel mono-composant selon un premier mode de réalisation particulier de l'invention (neurone 3D) ;
- les figures 4A, 4B présentent chacune un exemple de structure d'un neurone artificiel mono-composant selon un deuxième mode de réalisation particulier de l'invention (neurone 2D) ;
- les figures 5A, 5B, 5C présentent chacune un exemple de structure d'un neurone artificiel mono-composant selon un troisième mode de réalisation particulier de l'invention (neurone 1D) ;
- la figure 6 présente la structure d'un réseau de trois neurones artificiels mono-composants selon un mode de réalisation particulier de l'invention ;
- les figures 7A, 7B, 7C présentent, sous forme de chronogrammes, l'évolution de signaux électriques illustrant le principe de fonctionnement d'un neurone artificiel du type intègre avec fuite et tire (LIF) ;
- la figure 8 représente un schéma de montage expérimental utilisé pour l'application d'impulsions électriques et la mise en évidence du comportement intègre avec fuite et tire (LIF) du neurone artificiel mono-composant selon l'invention ;
- la figure 9 représente un schéma de principe d'une série d'impulsions électriques pouvant être appliquée au dispositif expérimental décrit en figure 8 ;
- la figure 10 présente un ensemble de courbes expérimentales illustrant le phénomène de transition résistive volatile induit par impulsion électrique dans le dispositif expérimental décrit en figure 8 ;
- la figure 11 présente deux courbes expérimentales permettant d'une part de mettre en évidence le caractère volatile de la transition résistive et d'autre part de déterminer le temps de relaxation $\tau$ associé au phénomène de fuite du neurone artificiel mono-composant selon l'invention.
- les figures 12A, 12B, 12C présentent un ensemble de courbes expérimentales obtenues pour le dispositif expérimental décrit en figure 8 et qui illustrent les fonctions intègre avec fuite et tire (LIF) du neurone artificiel mono-composant selon l'invention ;
- les figures 13A, 13B, présentent la correspondance entre les données expérimentales obtenues pour le dispositif expérimental décrit en figure 8 et la théorie du modèle LIF.

## 6. DESCRIPTION DÉTAILLÉE

Sur toutes les figures du présent document, les éléments identiques sont désignés par une même référence numérique.

L'invention propose un neurone artificiel monocomposant de conception nouvelle conforme au modèle de référence LIF (*« Leaky Integrate and Fire »*).

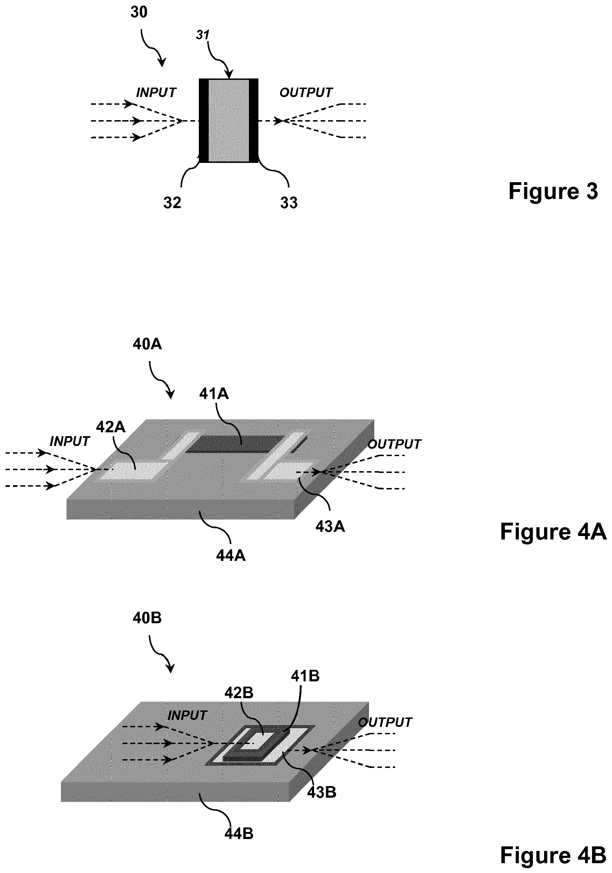

La **figure 3** présente un exemple de structure d'un neurone artificiel mono-composant 30 selon un premier mode de réalisation particulier de l'invention (structure tridimensionnelle).

Le neurone artificiel mono-composant 30 représenté sur cette figure est constitué d'un unique dipôle électrique comprenant un morceau de cristal de matériau 31 appartenant à la famille des isolants de Mott, par exemple le composé de formule $GaTa_4Se_8$, connecté par deux électrodes 32 et 33. Les deux électrodes 32, 33 sont constituées chacune d'un matériau électriquement conducteur.

Comme décrit plus en détails ci-dessous en relation avec les figures 8 à 13, le neurone artificiel mono-composant 30 ainsi obtenu selon l'invention est de type intègre avec fuite et tire, c'est-à-dire qu'il remplit les trois fonctions du neurone artificiel conformes au modèle de référence LIF.

Dans cet exemple, le matériau isolant de Mott 31 est un bloc de cristal taillé d'épaisseur 20 $\mu$m, de longueur 300 $\mu$m et de largeur 200 $\mu$m. Chaque électrode électrique se présente typiquement sous la forme d'une couche mince d'épaisseur 0,1 $\mu$m, de longueur 300 $\mu$m et de largeur 200 $\mu$m. Il convient de noter que ces dimensions sont données à titre purement illustratif et peuvent bien entendu être différentes.

Dans ce mode de réalisation particulier, le bloc de cristal 31 étant de structure tridimensionnel (3D), le neurone 30 selon l'invention est assimilé à un neurone artificiel tridimensionnel (3D).

De manière générale, les dimensions du morceau de cristal isolant de Mott 31, des électrodes électriques 32, 33 et leur agencement par rapport au dit morceau de cristal, ainsi que le choix des matériaux peuvent être optimisés de façon à ce que le neurone artificiel mono-composant 30 ainsi obtenu puisse bénéficier des meilleures performances (qualité de la réponse du dipôle électrique par rapport à celle attendue dans le modèle LIF du neurone artificiel, intégration structurelle, etc.).

On décrit ci-après les étapes principales du procédé de fabrication du neurone artificiel mono-composant 30 représenté sur la figure 3.

On procède tout d'abord à la découpe d'un morceau de cristal de $GaTa_4Se_8$ constituant le matériau fonctionnel du neurone artificiel mono-composant 30. Puis on procède au dépôt, sur les deux faces opposées du morceau de cristal 31, d'un matériau conducteur constituant les électrodes d'entrée 32 (notée « INPUT » sur la figure) et de sortie 33 (notée « OUTPUT » sur la figure) du neurone artificiel.

Ce dépôt peut être réalisé typiquement soit en appliquant directement sur les faces du cristal une laque conductrice soit en utilisant une technique de dépôt comme par exemple l'évaporation par effet Joule ou la pulvérisation magnétron (PVD pour *« Physical Vapor Deposition »*).

Les **figures 4A et 4B** présentent deux exemples de structure d'un neurone artificiel mono-composant 30 selon un deuxième mode de réalisation particulier de l'invention (structure bidimensionnelle).

Le neurone artificiel mono-composant 40A représenté sur la **figure 4A** est constitué d'un unique dipôle électrique comprenant une couche de matériau 41A appartenant à la famille des isolants de Mott, par exemple le composé de formule $GaV_4S_8$, connecté par deux électrodes électriquement conductrices 42A et 43A.

Le dipôle électrique est supporté par un substrat isolant 44A. C'est donc le dipôle électrique 40A comme simple composant électronique élémentaire qui se comporte comme un neurone artificiel, le substrat isolant 44A ne jouant que le rôle de support du dispositif de l'invention. Comme décrit plus en détails ci-dessous en relation avec les figures 8 à 13, le neurone artificiel mono-composant 40A ainsi obtenu selon l'invention est de type intègre avec fuite et tire, c'est-à-dire qu'il remplit les trois fonctions du neurone artificiel conformes au modèle de référence LIF.

Dans l'exemple de réalisation illustré ici, la première électrode 42A se présente sous la forme d'un L est disposée en partie sur une première extrémité de la couche d'isolant de Mott 41A, l'autre partie s'étendant sur le substrat isolant 44A. Cette électrode forme l'entrée du neurone artificiel mono-composant 40A (notée « INPUT » sur la figure). La deuxième électrode 43A se présente sous la forme d'un L et est disposée en partie sur la seconde extrémité de la couche d'isolant de Mott 41A, l'autre partie s'étendant sur le substrat isolant 44A. Cette électrode forme la sortie du neurone artificiel mono-composant 40A (notée « OUTPUT » sur la figure).

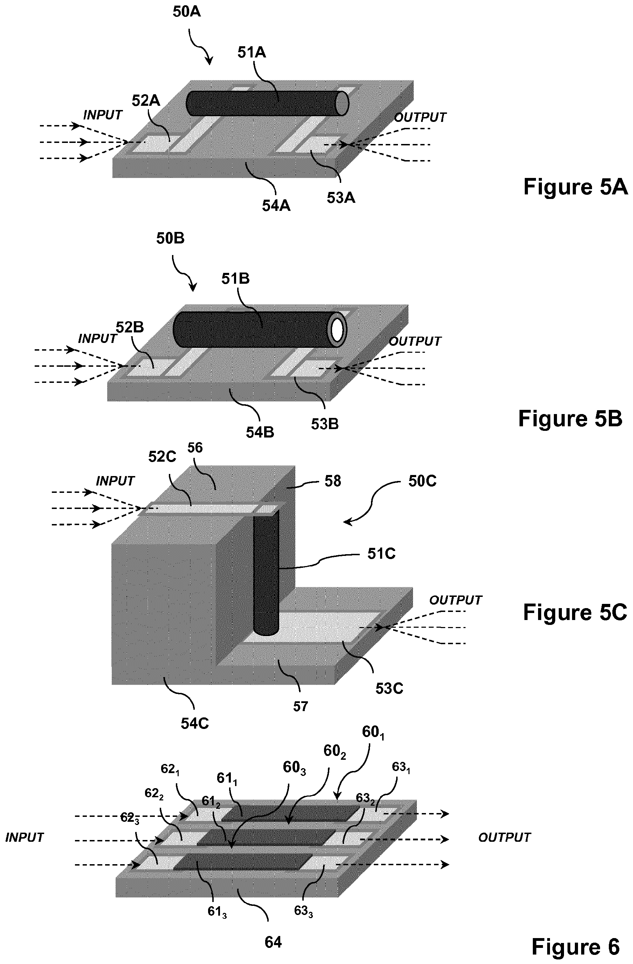

On remarque ici que le jeu d'électrodes 42A, 43A est disposé sur la couche d'isolant de Mott 41A, autrement dit une fois que la couche d'isolant de Mott 41A a été déposée sur le substrat 44A. Il s'agit bien sûr d'un exemple de structure particulier. Il est clair que de nombreuses autres structures de neurone artificiel mono-composant peuvent être envisagées, sans sortir du cadre de l'invention. On peut notamment prévoir par exemple une structure de neurone selon laquelle les électrodes sont agencées sous la couche d'isolant de Mott 41A (comme c'est le cas dans le mode de réalisation particulier illustré à la figure 6). On peut également prévoir par exemple que la couche d'isolant de Mott soit disposée en sandwich entre les électrodes, tel que représenté sur la **figure 4B.** De même, la forme et les dimensions des électrodes peuvent également varier en fonction de l'architecture neuromorphique désirée.

Le neurone artificiel mono-composant 40B représenté dans la **figure 4B** est constitué d'un unique dipôle électrique comprenant une couche de matériau 41B, de formule $GaV_4S_8$, prise en sandwich entre les électrodes 42A et 43A. Le tout est disposé sur une plaque substrat 44B.

Dans ces deux exemples, la couche de matériau isolant de Mott est une couche mince d'épaisseur 0.1 $\mu$m, de longueur 20 $\mu$m et de largeur 1 $\mu$m. Chaque électrode a une épaisseur de 0.1 $\mu$m.

On entend par « couche mince », dans la suite de ce document, une couche de matériau dont l'épaisseur est généralement inférieure à 10 $\mu$m, par opposition aux « couches épaisses » dont l'épaisseur est généralement supérieure à 10 $\mu$m.

Il convient de noter que ces dimensions sont données à titre purement illustratif et peuvent bien entendu être différentes.

Dans ce mode de réalisation particulier, on considère que la couche mince de matériau isolant de Mott présente une structure bidimensionnel (2D). Le neurone 40A ou 40B selon l'invention peut donc être assimilé à un neurone artificiel bidimensionnel (2D).

De manière générale, les dimensions de la couche d'isolant de Mott, des électrodes métalliques et leur agencement par rapport à ladite couche, ainsi que le choix des matériaux peuvent être optimisées de façon à ce que le neurone artificiel mono-composant ainsi obtenu puisse bénéficier des meilleures performances (qualité de la réponse du dipôle électrique par rapport à celle attendue dans le modèle LIF du neurone artificiel, intégration structurelle, etc.).

On décrit ci-après les étapes principales du procédé de fabrication du neurone artificiel mono-composant 40A représenté sur la figure 4A.

On procède tout d'abord au dépôt, sur une plaque de substrat (un wafer de silicium oxydé par exemple), d'une couche de $GaV_4S_8$ constituant le matériau fonctionnel du neurone artificiel mono-composant 40A. Ce dépôt peut être réalisé typiquement au moyen d'une technique de dépôt comme par exemple : l'évaporation par effet Joule, la pulvérisation magnétron (PVD), le dépôt par impulsions laser (PLD pour *« Pulse Laser Déposition »*), le dépôt par couche atomique (ALD pour *"Atomic Layer Deposition"*), le dépôt par solutions chimiques (CSD pour *« Chemical solution deposition »*), le dépôt par sérigraphie, le dépôt par tournette/trempage (*« Spin/Dip coating »* en anglais). Puis, on procède au dépôt d'un matériau métallique constituant les électrodes d'entrée 42A et de sortie 43A du neurone, comme expliqué ci-dessus en relation avec la figure 3.

Pour le neurone artificiel mono-composant 40B, on procède tout d'abord au dépôt, sur une plaque de substrat (un wafer de silicium oxydé par exemple), d'une couche de matériau métallique constituant l'électrode de sortie 43B selon une technique d'évaporation par effet Joule ou de pulvérisation magnétron par exemple. Puis, on procède au dépôt sur ladite couche de matériau métallique 43B d'une couche de $GaV_4S_8$ constituant le matériau fonctionnel 41B du neurone artificiel mono-composant 40B au moyen d'une des techniques de dépôt décrites ci-dessus en relation avec la figure 4A. Enfin, on procède au dépôt d'une autre couche de matériau métallique constituant l'électrode d'entrée 42B du neurone.

Les **figures 5A et 5B** présentent deux exemples de structure d'un neurone artificiel monocomposant selon un troisième mode de réalisation particulier de l'invention (structure unidimensionnelle).

Le neurone artificiel mono-composant 50A représenté sur la **figure 5A** est constitué d'un unique dipôle électrique comprenant un nanofil d'isolant de Mott 51A de formule $(V_{1-x}Cr_x)_2O_3$, connecté par deux électrodes 52A et 53A.

Le dipôle électrique est supporté par un substrat isolant 54A. C'est donc le dipôle électrique 50A comme simple composant électronique élémentaire qui se comporte comme un neurone artificiel, le substrat isolant 54A ne jouant que le rôle de support du dispositif de l'invention. Comme décrit plus en détails ci-dessous en relation avec les figures 8 à 13, le neurone artificiel mono-composant 50A ainsi obtenu selon l'invention est de type intègre avec fuite et tire, c'est-à-dire qu'il remplit les trois fonctions du neurone artificiel conformes au modèle de référence LIF.

Dans l'exemple de réalisation illustré ici, la première électrode 52A est disposée en partie sous une première extrémité du nanofil d'isolant de Mott 51A, l'autre partie s'étendant sur le substrat isolant 54A. Cette électrode forme l'entrée du neurone artificiel mono-composant 50A (notée « INPUT » sur la figure). La deuxième électrode 53A est disposée en partie sous la seconde extrémité du nano-fil d'isolant de Mott 51A, l'autre partie s'étendant sur le substrat isolant 54A. Cette électrode forme la sortie du neurone artificiel mono-composant 50A (notée « OUTPUT » sur la figure).

On remarque ici que le jeu d'électrodes 52A, 53A est disposé sous le nano-fil d'isolant de Mott 51A, autrement dit avant que le nano-fil d'isolant de Mott 51A n'ait été déposé sur le substrat 54A. Il s'agit bien sûr d'un exemple de structure particulier. Il est clair que de nombreuses autres structures de neurone artificiel mono-composant peuvent être envisagées, sans sortir du cadre de l'invention.

On décrit ci-après les étapes principales du procédé de fabrication du neurone artificiel mono-composant 50A représenté sur la figure 5A.

On procède tout d'abord au dépôt, sur une plaque de substrat (un wafer de silicium par exemple), d'une couche de matériau métallique constituant les deux électrodes d'entrée et de sortie du neurone. Ce dépôt peut être réalisé typiquement au moyen de l'une des techniques suivantes par exemple : évaporation par effet Joule, pulvérisation magnétron (PVD), dépôt par impulsions laser (PLD), dépôt par couche atomique (ALD), dépôt par solutions chimiques (CSD), dépôt par sérigraphie, dépôt par tournette/trempage (« *Spin*/*Dip coating* »). Puis, on procède au positionnement du nano-fil de façon à ce qu'il touche à la fois les deux électrodes 52A et 53A, le nano-fil ayant était préalablement synthétisé au moyen d'une méthode Vapeur-Liquide-Solide (VLS) ou template par exemple.

L'exemple de la **figure 5B** diffère de celui de la figure 5A en ce que le neurone artificiel 50B est constitué, non pas d'un nano-fil d'isolant de Mott, mais d'un nano-tube d'isolant de Mott 51B. Le reste de la structure de ce neurone artificiel 50B est identique au neurone artificiel 50A. Une électrode conductrice d'entrée 52B est agencée sous le nano-tube 51B au niveau de l'une de ses extrémités et une électrode conductrice de sortie 53B est agencée sous le nano-tube 51B au niveau de l'autre de ses extrémités, le tout étant disposé sur un substrat isolant 54B.

Le neurone artificiel 50C représenté sur la **figure 5C** est constitué d'un dipôle électrique comprenant un nanofil d'isolant de Mott 51C de formule $V_{2-x}Cr_xO_3$, connecté par deux électrodes 52C et 53C.

Dans ce troisième exemple, le dipôle électrique est supporté par un substrat isolant 54C de forme générale en L, présentant deux surfaces 56 et 57 sensiblement parallèles sur lesquelles sont agencées respectivement les couches de matériau formant les électrodes d'entrée 52C et de sortie 53C du neurone artificiel. Les deux surfaces 56 et 57 sont reliées par une troisième surface 58 sur laquelle est agencé le nanofil 51C de sorte que les sections d'extrémité de celui-ci soient connectées aux électrodes d'entrée 52C et de sortie 53C du neurone.

On procède tout d'abord au dépôt, sur le substrat en forme de L, au niveau de la surface 57, d'une couche de matériau métallique constituant l'électrode de sortie 53C du neurone, par exemple par évaporation par effet Joule. Puis, on agence le nano-fil 51C de sorte que l'une de ses extrémités soit en contact avec l'électrode de sortie 53C et de sorte qu'une partie de la surface circonférentielle du nanofil s'étende le long de la surface 58 en direction de la surface 56, le nano-fil ayant été préalablement synthétisé au moyen d'une méthode Vapeur-Liquide-Solide (VLS) ou template par exemple. Enfin, on procède au dépôt d'une autre couche de matériau métallique au niveau de l'extrémité libre du nano-fil et de la surface 56 pour constituer l'électrode d'entrée 52C du neurone, par exemple par évaporation par effet Joule.

Dans ce mode de réalisation particulier, on considère que le nano-fil ou nano-tube d'isolant de Mott présente une structure unidimensionnel (1D). Le neurone 50A, 50B ou 50C selon l'invention peut donc être assimilé à un neurone artificiel unidimensionnel (1D).

Dans le neurone artificiel tel que décrit précédemment, dans l'un quelconque de ses différents modes de réalisation (1D, 2D, 3D), les électrodes d'entrée et de sortie peuvent être réalisées dans l'un des matériaux suivants : un élément simple tel que le Platine (Pt), l'Or (Au), l'argent (Ag), le Molybdène (Mo), le Graphite (C), l'Aluminium (Al), le Cuivre (Cu), le Silicium dopé (Si)) ou un alliage tel que le laiton, l'acier, le bronze par exemple ou encore un composé de métaux de transition tel que TiN, TaN, $RuO_2$, $SrRuO_3$, $CuS_2$.

En vue d'une intégration dans un réseau de neurones artificiels, chaque électrode du neurone artificiel mono-composant tel que décrit précédemment, dans l'un quelconque de ses différents modes de réalisation (1D, 2D, 3D), est configurée pour être reliée à une ou plusieurs synapses artificielles (non illustrées sur la figure), comme par exemple les synapses artificielles w selon l'architecture neuromorphique représentée sur la figure 1 (où chaque neurone artificiel est configuré pour être connecté à un ensemble de trois synapses en entrée et trois synapses en sortie).

Le réseau de neurones selon l'invention comprend une pluralité de neurones artificiels interconnectés entre eux par des synapses artificielles. Dans un mode de réalisation particulier (mode « dégradé »), on peut envisager un réseau de neurones artificiels dont certains sont des neurones artificiels mono-composant selon l'invention et d'autres sont des neurones de l'état de l'art. Dans un autre mode de réalisation (mode préférentiel), chaque neurone artificiel du réseau est un neurone artificiel mono-composant tel que défini selon l'invention.

La **figure 6** présente un réseau de trois neurones artificiels mono-composant $60_1$, $60_2$, $60_3$, selon un mode de réalisation particulier de l'invention.

Le neurone artificiel mono-composant $60_1$ est formé d'un dipôle électrique comprenant une couche mince $61_1$ de matériau $GaV_4S_8$ dont les extrémités sont mises en contact avec un jeu d'électrodes métalliques jouant le rôle d'entrée/sortie du neurone : la première extrémité de ladite couche de $GaV_4S_8$ est contactée avec l'électrode d'entrée $62_1$ et la seconde extrémité de ladite couche de $GaV_4S_8$ est contactée avec l'électrode de sortie $63_1$.

Le neurone artificiel mono-composant $60_2$ est formé d'un dipôle électrique comprenant une couche mince $61_2$ de matériau $GaV_4S_8$ dont les extrémités sont mises en contact avec un jeu d'électrodes métalliques jouant le rôle d'entrée/sortie du neurone : la première extrémité de ladite couche de $GaV_4S_8$ est contactée avec l'électrode d'entrée $62_2$ et la seconde extrémité de ladite couche de $GaV_4S_8$ est contactée avec l'électrode de sortie $63_2$.

Le neurone artificiel mono-composant $60_3$ est formé d'un dipôle électrique comprenant une couche mince $61_3$ de matériau $GaV_4S_8$ dont les extrémités sont mises en contact avec un jeu d'électrodes métalliques jouant le rôle d'entrée/sortie du neurone : la première extrémité de ladite couche de $GaV_4S_8$ est contactée avec l'électrode d'entrée $62_3$ et la seconde extrémité de ladite couche de $GaV_4S_8$ est contactée avec l'électrode de sortie $63_3$.

Chaque neurone artificiel mono-composant a été obtenu au moyen du procédé de fabrication décrit ci-dessus en relation avec la figure 3 sur une plaque de substrat isolant 64 à la différence que les électrodes d'entrée/sortie sont ici de forme allongée droite et qu'elles sont placées en-dessous des couches minces de $GaV_4S_8$.

On peut envisager que ces neurones artificiels mono-composant puissent être connectés à des synapses artificielles (non illustrées sur la figure) au niveau de l'entrée (INPUT) et de la sortie (OUTPUT) de chaque neurone de façon à intégrer un réseau neuronal artificiel (comme l'exemple d'architecture neuromorphique représenté sur la figure 1 où chaque neurone est connecté à un ensemble de trois synapses en entrée et trois synapses en sortie).

On peut également envisager de réaliser des réseaux de neurones artificiels avec d'une part un nombre de neurones artificiels supérieur à trois et d'autre part comprenant des neurones artificiels soit à base de morceau de cristal d'isolant de Mott, soit à base de couche mince d'isolant de Mott, soit à base de nanofil ou de nanotube d'isolant de Mott.

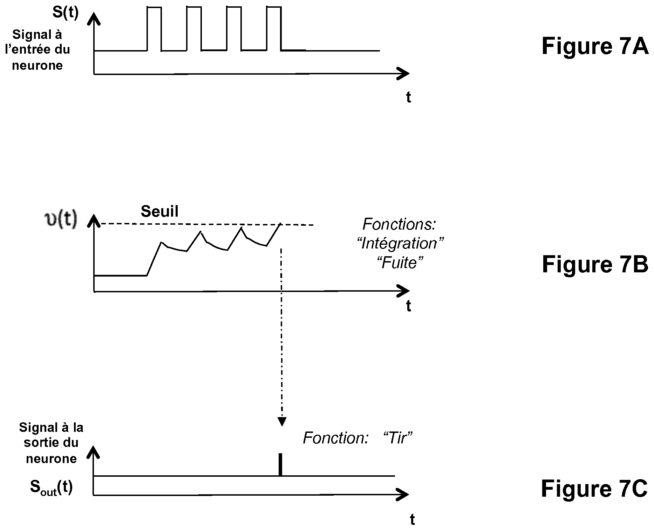

Les **figures 7A, 7B, 7C,** présentent, sous forme de chronogrammes, l'évolution de signaux électriques illustrant le principe de fonctionnement d'un neurone artificiel du type intègre avec fuite et tire (LIF).

Un neurone artificiel de type LIF reçoit une série d'impulsion S(t) pondérée par le poids synaptique $w$ (Figure 7A). Le neurone artificiel intègre (« *Integrate* ») alors temporellement une fonction de ce signal d'entrée ; la quantité correspondante au résultat de cette intégration par le neurone artificiel se relaxe au cours du temps (« *Leaky* ») donnant ainsi le signal $v(t)$ (Figure 7B). Ce signal $v(t)$ est l'équivalent du potentiel de membrane pré-synaptique pour un neurone biologique. Le neurone artificiel déclenche un signal en sortie (« *Fire* ») lorsque le signal $v(t)$ atteint un seuil donné. Ce signal de sortie $S_{out}(t)$ (Figure 7C) est une impulsion dont la forme n'est pas explicitement définie dans le modèle LIF.

Le neurone artificiel selon le modèle LIF remplit donc les trois fonctions suivantes : intégration avec fuite et tir. La partie expérimentale décrite ci-après montre que les isolants de Mott présentent les propriétés requises pour se comporter comme un neurone artificiel selon le modèle LIF.

La **figure 8** représente un schéma de montage expérimental utilisé pour l'application d'impulsions électriques et la mise en évidence du comportement intègre avec fuite et tire (LIF) du neurone artificiel mono-composant conforme à l'invention.

Il comprend un générateur d'impulsions électriques 83 monté en série avec un dispositif expérimental constitué d'une conductance noté « $w$ » 84 jouant le rôle d'une synapse artificielle elle-même montée en série avec un morceau de cristal de matériau fonctionnel 80 agencé entre deux électrodes métalliques 81 et 82.

L'objectif a été de tester la réponse du matériau fonctionnel 80 à l'application de différentes séries d'impulsions électriques émises par le générateur 83. Le matériau fonctionnel 80 est ici un morceau de cristal de $GaTa_4Se_8$ qui a été préalablement synthétisé, puis clivé. Il s'agit de l'un des composés appartenant à la famille des isolants de Mott $AM_4Q_8$, avec A qui comprend l'un au moins des éléments suivants : Ga, Ge, Zn, M qui comprend l'un au moins des éléments suivants : V, Nb, Ta, Mo et Q qui comprend l'un au moins des éléments suivants : S, Se, Te.

Le matériau fonctionnel 80 présente typiquement les dimensions suivantes : 300 $\mu$m de long, 200 $\mu$m de large et 20 $\mu$m d'épaisseur. Les deux électrodes métalliques 81 et 82 sont formées par exemple au moyen d'une laque de carbone.

La tension aux bornes de la conductance « $w$ » 84 (notée $V_w$) et la tension aux bornes du matériau fonctionnel 80 (notée V) sont mesurées à l'aide d'un oscilloscope. La tension des impulsions est définie selon la relation $V_{total}$ = V + $V_w$ et la résistance du matériau fonctionnel (notée $R$) est calculée selon la loi d'Ohm: $R$ = V/I, où $I$ = $w$ $V_w$.

Pour simplifier le montage en pratique, le matériau fonctionnel 80 ne reçoit des signaux électriques que du seul générateur d'impulsions 83. Cependant, il n'y a aucun obstacle à ce que ce matériau fonctionnel soit connecté à plusieurs sources d'impulsions différentes, afin de mimer le grand nombre de connexions synaptiques qui peut exister dans un réseau neuronal artificiel.

La **figure 9** illustre schématiquement les principales caractéristiques de la série d'impulsions électriques envoyée par le générateur : la durée $t_{ON}$ des impulsions électriques, la durée $t_{OFF}$ s'écoulant entre deux impulsions successives, la tension $V_{total}$ de chaque impulsion et le nombre N d'impulsions émises dans la série.

La **figure 10** montre la réponse du matériau fonctionnel 80 lorsque le circuit de la figure 8 est soumis à une seule impulsion électrique de longue durée (supérieure à 100 µs) et d'amplitude d'environ 60 V. Cette réponse est ici caractérisée par la tension V obtenue aux bornes du matériau fonctionnel 80, le courant I le traversant et sa résistance électrique R.

Au bout d'une durée égale à 70 µs environ ($t_{Fire}$ = 70 µs) après le début de l'impulsion électrique, une brusque chute de la tension V est observée aux bornes du matériau fonctionnel 80, concomitante à une forte augmentation du courant $I$ qui le traverse (voir les caractéristiques $I(t)$ et $V(t)$ montrées sur la figure 10), et donc une forte chute de la résistance. Ces courbes expérimentales mettent en exergue le phénomène physique de transition résistive à partir d'un seuil de champ électrique. Pour le composé $GaTa_4Se_8$ la valeur du champ électrique seuil est environ égale à 2,5 kV/cm ce qui correspond à une tension seuil ($V_{seuil}$) égale à 10V dans cet exemple. La valeur seuil du champ électrique varie en loi de puissance avec l'énergie de bande interdite des composés isolants de Mott et peut donc être déterminée selon cette loi. Il est donc possible par le choix de l'isolant de Mott utilisé d'optimiser la valeur de ce champ seuil en fonction des caractéristiques souhaitées.

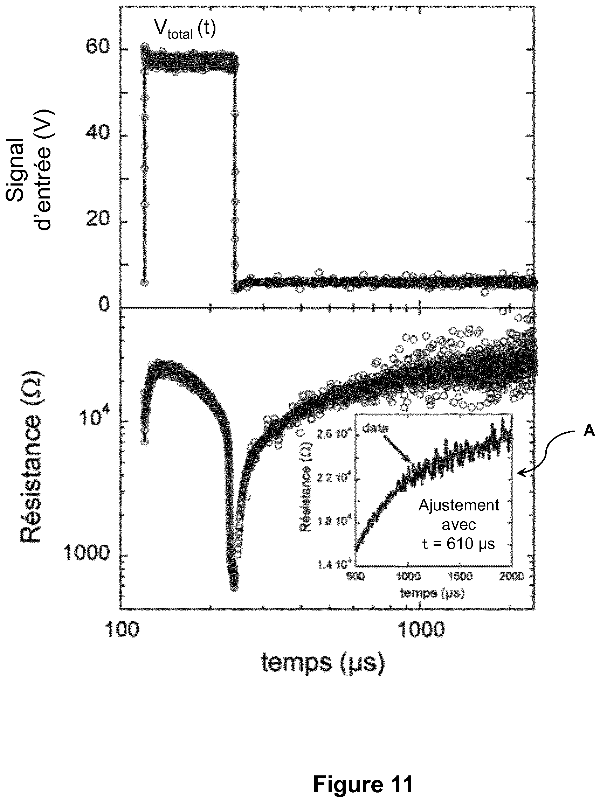

La **figure 11** présente deux courbes expérimentales obtenues pour le matériau fonctionnel du montage expérimental de la figure 8, permettant d'illustrer que la résistance du matériau fonctionnel revient à son état initial après le pulse et donc que la transition résistive est volatile.

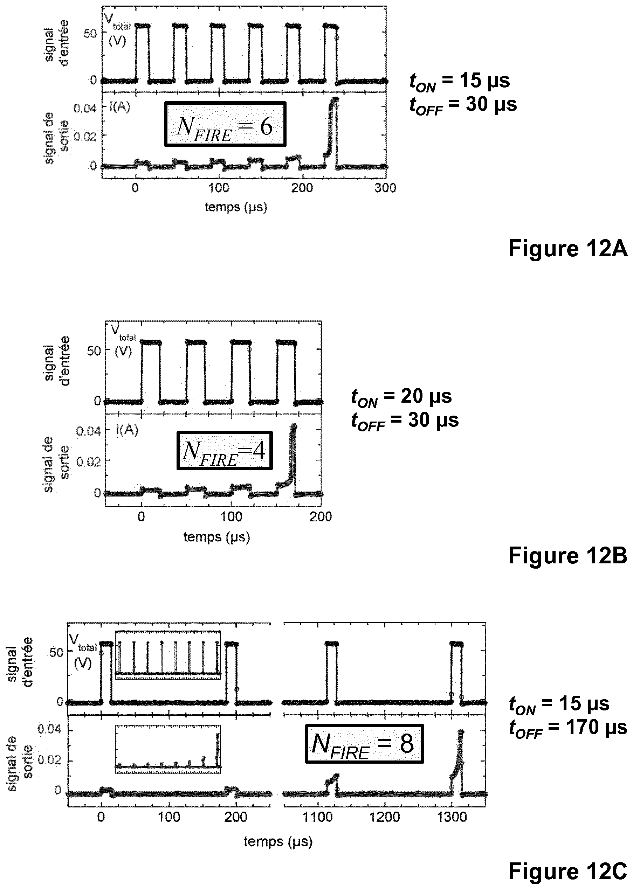

Ces courbes expérimentales ont été obtenues dans les mêmes conditions que celles décrites sur les figures 10, 12A-C. Le premier graphique montre l'évolution de la tension $V_{total}$ appliquée au matériau fonctionnel 80 et le deuxième graphique montre l'évolution de sa résistance au cours du temps.

On s'aperçoit que la résistance $R$ du matériau fonctionnel 80, après que la transition résistive a été réalisée (c'est-à-dire après la forte chute de la résistance due au pulse électrique), se relaxe jusqu'à retrouver son état d'équilibre selon une loi en exponentielle décroissante. L'affinement des données montré dans l'insert A de la Figure 10, permet de déterminer le temps caractéristique de la relaxation : $\tau \approx 610$ µs.

L'application d'impulsions électriques permet donc de faire varier, de manière volatile, la résistance de ce matériau entre au moins deux états de résistance distincts. Partant de ce constat, les inventeurs ont découvert que cette propriété des isolants de Mott pouvait être exploitée pour implémenter un neurone artificiel mono-composant du type intègre avec fuite et tire (LIF).

On présente maintenant, en relation avec les **figures 12A, 12B, 12C,** un ensemble de courbes expérimentales obtenues pour le matériau fonctionnel 80 qui illustrent la faisabilité des fonctions intègre avec fuite et tire (LIF) du neurone artificiel mono-composant selon l'invention.

La **figure 12A** montre la réponse du matériau fonctionnel 80 (le signal de sortie est l'intensité du courant électrique /), lorsque le circuit de la figure 8 est soumis à une série de six impulsions électriques de durée $t_{ON}$ = 15 µs, séparées les unes des autres d'une durée $t_{OFF}$ = 30 µs, et d'amplitude d'environ 60 V (signal d'entrée $V_{total}$).

Après avoir appliqué une série de six impulsions électriques au matériau fonctionnel 80, une brusque augmentation du courant I traversant le matériau fonctionnel 80 est observée. L'apparition soudaine de cette forte augmentation du courant I lorsque la sixième impulsion électrique est appliquée montre qu'un signal (« *spike* ») a été déclenché par le matériau fonctionnel 80.

Ce résultat est très important puisqu'il prouve que le matériau fonctionnel réalise d'une part la fonction « tir », et d'autre part, une intégration d'une fonction du signal d'entrée $V_{total}$. En effet, chaque impulsion électrique n'a pas, seule, d'effet notable puisque sa durée est inférieure à $t_{fire}$ = 70 µs (voir figure 10), alors que plusieurs impulsions électriques successives ont pour effet d'induire le phénomène de « tir ». Ce résultat montre donc la réalisation des fonctions « tir » (ou « *Fire* » en anglais) et « intégration » (ou « *integrate* » en anglais) c'est-à-dire deux des trois fonctions requises par le modèle LIF.

Le phénomène d'intégration est aussi confirmé par une série d'expériences menées en conservant la durée $t_{OFF}$ entre deux impulsions successives constante et en faisant varier la durée $t_{ON}$ des impulsions électriques.

La **figure 12B** montre la réponse du matériau fonctionnel 80 (signal de sortie /), lorsque le circuit de la figure 8 est soumis à une série de quatre impulsions électriques de durée $t_{ON}$ de 20 µs, séparées les unes des autres d'une durée $t_{OFF}$ de 30 µs, et d'amplitude d'environ 60 V (signal d'entrée $V_{total}$). Ainsi, la figure 12B présente la même expérience que celle décrite sur la figure 12A, mais avec une durée $t_{ON}$ des impulsions électriques appliquées au matériau fonctionnel augmentée (on passe d'une durée $t_{ON}$ de 15 à 20 µs).

On s'aperçoit ici que le nombre d'impulsions nécessaires pour que le matériau fonctionnel 80 déclenche un signal de sortie (« *spike* ») diminue lorsque la durée $t_{ON}$ des impulsions électriques augmente (on passe de 6 à 4 impulsions nécessaires). Ceci permet là encore de montrer que le dispositif expérimental est capable de mettre en œuvre les fonctions « Intégration » (« *Integrate* ») et « Tir » (« *Fire* »), c'est-à-dire deux des trois fonctions du modèle standard LIF.

La **figure 12C** présente la même expérience que celle décrite sur la figure 12A, mais avec une durée $t_{OFF}$ entre deux impulsions successives plus élevée (170 µs contre 30 µs précédemment). Le résultat est très clair : le nombre d'impulsions électriques nécessaire pour que le matériau fonctionnel 80 déclenche un signal de sortie (« *spike* ») a augmenté, passant de six a huit impulsions. Cela prouve que le signal intégré par le matériau fonctionnel se relaxe au cours du temps, ce qui traduit une forme de fuite (« *leaky* »). Ceci permet de montrer que le matériau fonctionnel est capable de mettre en œuvre, non seulement les fonctions d'intégration (« *Integrate* ») et de tir (« *Fire* »), mais également la fonction de fuite (« Leaky ») du modèle standard LIF.

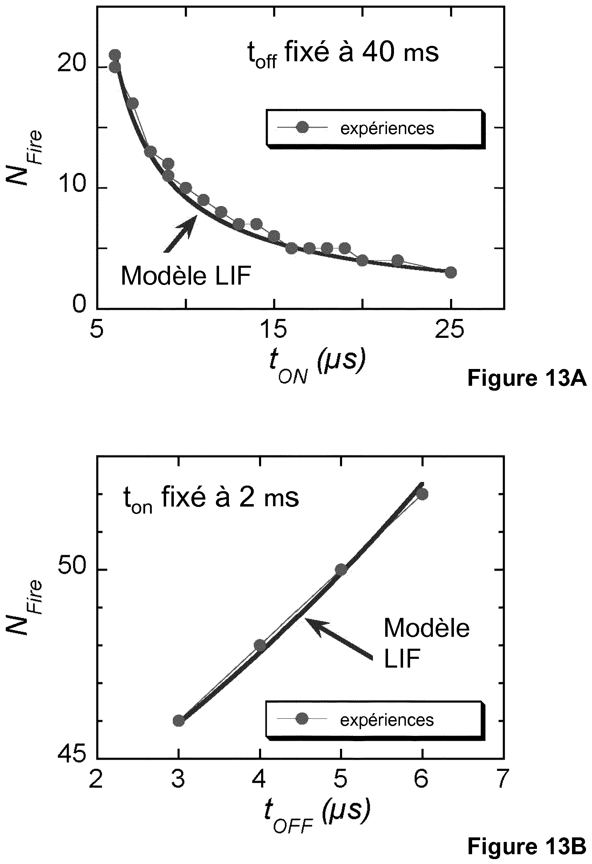

La **figure 13** présente la dépendance expérimentale du nombre d'impulsions nécessaires pour tirer ($N_{Fire}$) avec la durée $t_{on}$ (figure 13A) et la durée $t_{off}$ (figure 13B) obtenue lors d'expériences similaires à celles décrites sur les figures 12A-C.

On observe un très bon accord entre les points expérimentaux et la relation théorique :

$$N_{Fire} = -\frac{\tau}{t_{off}} \ln\left\{1 - \frac{\tau}{t_{on}} \times \left[1 - exp\left(\frac{-t_{off}}{\tau}\right)\right] \times \left[1 - exp\left(\frac{-t_{Fire}}{\tau}\right)\right]\right\} \quad \text{équation (2)}$$

obtenue par le développement mathématique du modèle LIF dans le cas d'impulsions électriques carrées (dont le principe est décrit plus haut en relation avec l'état de l'art).

Ce très bon accord est d'autant plus remarquable que la dépendance théorique ne contient aucun paramètre ajustable puisque la durée $t_{Fire}$ et le temps de relaxation $\tau$ ont été fixés aux valeurs expérimentales ($t_{Fire}$ = 70µs et $\tau$ = 610 µs). Cela démontre que la prédiction mathématique du modèle LIF (équation (2)) s'applique au neurone artificiel mono-composant à base d'isolant de Mott de l'invention. Ce très bon accord prouve qu'il existe un seuil unique d'inté-gration, indépendant des durées $t_{on}$ et $t_{off}$, au-delà duquel le neurone artificiel selon l'invention déclenche la fonction tir.

L'ensemble de ces résultats expérimentaux prouve donc que le dispositif expérimental 80 à base d'isolant de Mott $GaTa_4Se_8$ réalise les trois fonctions essentielles du neurone artificiel décrit par le modèle LIF (« Leaky », *« Integrate », « Fire »*), à savoir l'intégration avec fuite et le tir au-delà d'un seuil. De plus, ces résultats montrent qu'il est possible de prédire, pour les neurones artificiels selon l'invention, le nombre d'impulsions électriques nécessaires pour générer la fonction « tir ».

Le neurone artificiel mono-composant décrit ci-dessus, dans l'un quelconque de ses différents modes de réalisation (1D, 2D, 3D), est basé sur l'utilisation d'un isolant de Mott de formule $GaTa_4Se_8$ ou $GaV_4S_8$. Il est clair que tout autre matériau appartenant à la famille des isolants de Mott peut être envisagé comme matériau fonctionnel d'un neurone artificiel mono-composant sans sortir du cadre de l'invention, comme par exemple :

- des composés de formule $AM_4Q_8$; avec A qui comprend l'un au moins des éléments suivants : Ga, Ge, Zn, M qui comprend l'un au moins des éléments suivants : V, Nb, Ta, Mo et Q qui comprend l'un au moins des éléments suivants : S, Se, Te ;
- des composés de formule $(V_{1-x}M_x)_2O_3$, avec $0 \le x \le 1$, M comprenant l'un au moins des éléments suivants : Ti, Cr, Fe, Al, ou Ga ;
- des composés de formule $NiS_{2-x}Se_x$, avec $0 \le x \le 1$.
- le composé de formule $VO_2$.
- des composés isolants de Mott organiques.

## Revendications

1. Neurone artificiel (30) mettant en œuvre les fonctions d'intégration, de fuite et de tir, **caractérisé en ce que** le neurone artificiel est un neurone artificiel de modèle de référence « Leaky, Integrate and Fire » et **en ce qu'**il est constitué d'un seul dipôle électrique mono-composant comprenant un matériau (31) appartenant à la famille des isolants de Mott connecté à deux électrodes électriques (32, 33).

2. Neurone artificiel selon la revendication 1, dans lequel ledit matériau isolant de Mott comprend :

- un composé de formule $AM_4Q_3$, avec A qui comprend l'un au moins des éléments suivants : Ga, Ge, Zn ; M qui comprend l'un au moins des éléments suivants : V, Nb, Ta, Mo et Q qui comprend l'un au moins des éléments suivants : S, Se, Te ; ou
- un composé inorganique de formule $(V_{1-x}M_x)_2O_3$, avec $0 \le x \le 1$, M comprenant l'un au moins des éléments suivants : Ti, Cr, Fe, Al ou Ga ; ou
- un composé inorganique de formule $NiS_{2-x}Se_x$, avec $0 \leq x \leq 1$ ; ou
- un composé de formule $VO_2$ ; ou
- un composé isolant de Mott organique.

**3.** Neurone artificiel selon l'une quelconque des revendications 1 et 2, dans lequel les deux électrodes électriques (32, 33) sont constituées chacune d'un matériau électriquement conducteur comprenant :

- un des éléments suivants: Platine (Pt), Or (Au), Molybdène (Mo), Graphite (C), Aluminium (Al), Cuivre (Cu), Silicium (Si) dopé; ou
- un des alliages suivants : Laiton (Cu-Zn), Acier (Fe-C), Bronze (Cu-Sn); ou
- un des composés de métaux de transition suivants: TiN, TaN, $RuO_2$, $SrRuO_3$, $CuS_2$).

**4.** Neurone artificiel selon l'une quelconque des revendications 1 à 3, dans lequel ledit matériau isolant de Mott se présente :

- sous la forme d'une couche mince ; ou
- sous la forme d'un bloc de cristal ; ou
- sous la forme d'un nanotube ; ou
- sous la forme d'un nanofil.

**5.** Réseau de neurones comprenant une pluralité de neurones artificiels, **caractérisé en ce qu'**au moins un neurone artificiel est selon l'une quelconque des revendications 1 à 4.

**6.** Circuit électronique neuromorphique comprenant une pluralité de neurones artificiels, **caractérisé en ce qu'**au moins un neurone artificiel est selon l'une quelconque des revendications 1 à 4.

**7.** Procédé de fabrication d'un neurone artificiel mettant en œuvre les fonctions d'intégration, de fuite et de tir, **caractérisé en ce qu'**il comprend les étapes suivantes :

- obtention d'un matériau appartenant à la famille des isolants de Mott,
- obtention d'un neurone artificiel de modèle de référence « Leaky, Integrate and Fire » constitué d'un seul dipôle électrique mono-composant, par dépôt d'une couche de matériau conducteur :

    * au niveau d'une première extrémité dudit matériau isolant de Mott pour former une première électrode électrique,
    * au niveau d'une seconde extrémité dudit matériau isolant de Mott pour former une seconde électrode électrique.

**8.** Procédé de fabrication selon la revendication 7, dans lequel ladite étape d'obtention d'un matériau est effectuée en découpant un bloc de cristal isolant de Mott, et dans lequel ladite étape de dépôt d'une couche de matériau conducteur est effectuée en fonction dudit bloc de cristal découpé.

**9.** Procédé de fabrication selon la revendication 7, dans lequel ladite étape d'obtention d'un matériau est effectuée en déposant, sur une plaque de substrat, une couche mince d'un matériau isolant de Mott,
et dans lequel ladite étape de dépôt d'une couche de matériau conducteur est effectuée en fonction de ladite couche mince déposée.

**10.** Procédé de fabrication selon la revendication 7, dans lequel ladite étape d'obtention d'un matériau est effectuée en déposant, sur une plaque de substrat, un nanotube à base d'un matériau isolant de Mott, et dans lequel ladite étape de dépôt d'une couche de matériau conducteur est effectuée en fonction dudit nanotube déposé.

**11.** Procédé de fabrication selon la revendication 7, dans lequel ladite étape d'obtention d'un matériau est effectuée en déposant, sur une plaque de substrat, un nanofil à base d'un matériau isolant de Mott,
et dans lequel ladite étape de dépôt d'une couche de matériau conducteur est effectuée en fonction dudit nanofil déposé.

**Patentansprüche**

1. Künstliches Neuron (30), das die Funktionen Integration, Leck und Feuern umsetzt, **dadurch gekennzeichnet, dass** das künstliche Neuron ein künstliches Neuron des Referenzmodells "Leaky, Integrate and Fire" ist, und dass es aus einem einzigen elektrischen Einkomponenten-Dipol gebildet ist, aufweisend ein Material (31), das zur Familie der Mott-Isolatoren gehört, verbunden mit zwei elektrischen Elektroden (32, 33).

2. Künstliches Neuron gemäß Anspruch 1, wobei das Mott-Isolatormaterial aufweist:

   - eine Verbindung der Formel $AM_4Q_8$, mit A, das mindestens eines der folgenden Elemente aufweist: Ga, Ge, Zn; M, das mindestens eines der folgenden Elemente aufweist: V, Nb, Ta, Mo; und Q, das mindestens eines der folgenden Elemente aufweist: S, Se, Te; oder
   - eine anorganische Verbindung der Formel $(V_{1-x}M_x)_2O_3$, wobei $0 \leq x \leq 1$, wobei M mindestens eines der folgenden Elemente aufweist: Ti, Cr, Fe, Al oder Ga; oder
   - eine anorganische Verbindung der Formel $NiS_{2-x}Se_x$, wobei $0 \leq x \leq 1$; oder
   - eine Verbindung der Formel $VO_2$; oder
   - eine organische Mott-Isolatorverbindung.

3. Künstliches Neuron gemäß irgendeinem der Ansprüche 1 und 2, wobei die zwei elektrischen Elektroden (32, 33) jeweils aus einem elektrisch leitfähigen Material gebildet sind, aufweisend:

   - eines der folgenden Elemente: Platin (Pt), Gold (Au), Molybdän (Mo), Graphit (C), Aluminium (Al), Kupfer (Cu), dotiertes Silicium (Si); oder
   - eine der folgenden Legierungen: Messing (Cu-Zn), Stahl (Fe-C), Bronze (Cu-Sn); oder
   - eine der folgenden Übergangsmetallverbindungen: TiN, TaN, $RuO_2$, $SrRuO_3$, $CuS_2$).

4. Künstliches Neuron gemäß irgendeinem der Ansprüche 1 bis 3, wobei das Mott-Isolatormaterial:

   - in Form einer Dünnschicht oder
   - in Form eines Kristallblocks oder
   - in Form einer Nanoröhre oder
   - in Form eines Nanodrahtes

   vorliegt.

5. Neuronales Netzwerk, aufweisend eine Mehrzahl von künstlichen Neuronen, **dadurch gekennzeichnet, dass** mindestens ein künstliches Neuron gemäß irgendeinem der Ansprüche 1 bis 4 ist.

6. Neuromorphe elektronische Schaltung, aufweisend eine Mehrzahl von künstlichen Neuronen, **dadurch gekennzeichnet, dass** mindestens ein künstliches Neuron gemäß irgendeinem der Ansprüche 1 bis 4 ist.

7. Verfahren zum Herstellen eines künstlichen Neurons, das die Funktionen Integration, Leck und Feuern umsetzt, **dadurch gekennzeichnet, dass** es die folgenden Schritte aufweist:

   - Erhalten eines Materials, das zur Familie der Mott-Isolatoren gehört,
   - Erhalten eines künstlichen Neurons des Referenzmodells "Leaky, Integrate and Fire", gebildet aus einem einzigen elektrischen Einkomponenten-Dipol, durch Aufbringen einer Schicht eines leitfähigen Materials:

     * an einem ersten Ende des Mott-Isolatormaterials, um eine erste elektrische Elektrode zu bilden,
     * an einem zweiten Ende des Mott-Isolatormaterials, um eine zweite elektrische Elektrode zu bilden.

8. Verfahren zum Herstellen gemäß Anspruch 7, wobei der Schritt des Erhaltens eines Materials durch Schneiden eines Mott-Isolator-Kristallblocks durchgeführt wird, und wobei der Schritt des Aufbringens einer Schicht eines leitfähigen Materials in Abhängigkeit von dem geschnittenen Kristallblock durchgeführt wird.

9. Verfahren zum Herstellen gemäß Anspruch 7, wobei der Schritt des Erhaltens eines Materials durch Aufbringen einer Dünnschicht eines Mott-Isolatormaterials auf eine Substratplatte durchgeführt wird, und wobei der Schritt des Aufbringens einer Schicht eines leitfähigen Materials in Abhängigkeit von der aufgebrachten Dünnschicht durchgeführt wird.

10. Verfahren zum Herstellen gemäß Anspruch 7, wobei der Schritt des Erhaltens eines Materials durch Aufbringen einer Nanoröhre auf Basis eines Mott-Isolatormaterials auf eine Substratplatte durchgeführt wird, und wobei der Schritt des Aufbringens einer Schicht eines leitfähigen Materials in Abhängigkeit von der aufgebrachten Nanoröhre durchgeführt wird.

11. Verfahren zum Herstellen gemäß Anspruch 7, wobei der Schritt des Erhaltens eines Materials durch Aufbringen eines Nanodrahtes auf Basis eines Mott-Isolatormaterials auf eine Substratplatte durchgeführt wird, und wobei der Schritt des Aufbringens einer Schicht eines leitfähigen Materials in Abhängigkeit von dem aufgebrachten Nanodraht durchgeführt wird.

## Claims

1. Artificial neuron (30) implementing integration, leakage and firing functions, **characterised in that** the artificial neuron is an artificial neuron of the "leaky integrate and fire" reference model, and **in that** it is composed of a single monocomponent electric dipole comprising a material (31) belonging to the family of the Mott insulators connected to two electrical electrodes (32, 33).

2. Artificial neuron according to claim 1, wherein said Mott insulator material comprises:

   - a compound of formula $AM_4Q_8$, where A comprises at least one of the following elements: Ga, Ge, Zn; M comprises at least one of the following elements: V, Nb, Ta, Mo; and Q comprises at least one of the following elements: S, Se, Te; or
   - an inorganic compound of formula $(V_{1-x}M_x)_2O_3$, where $0 \leq x \leq 1$, M comprising at least one of the following elements: Ti, Cr, Fe, Al or Ga; or
   - an inorganic compound of formula $NiS_{2-x}Se_x$, where $0 \leq x \leq 1$; or
   - a compound of formula $VO_2$; or
   - an organic Mott insulator compound.

3. Artificial neuron according to either claim 1 or claim 2, wherein the two electrical electrodes (32, 33) are each composed of an electrically conductive material comprising:

   - one of the following elements: platinum (Pt), gold (Au), molybdenum (Mo), graphite (C), aluminium (Al), copper (Cu), doped silicon (Si); or
   - one of the following alloys: brass (Cu-Zn), steel (Fe-C), bronze (Cu-Sn); or
   - one of the following transition metal compounds: TiN, TaN, $RuO_2$, $SrRuO_3$, $CuS_2$.

4. Artificial neuron according to any one of claims 1 to 3, wherein said Mott insulator material is:

   - in the form of a thin layer; or
   - in the form of a crystal block; or
   - in the form of a nanotube; or
   - in the form of a nanowire.

5. Neural network comprising a plurality of artificial neurons, **characterised in that** at least one artificial neuron is in accordance with any one of claims 1 to 4.

6. Neuromorphic electronic circuit comprising a plurality of artificial neurons, **characterised in that** at least one artificial neuron is in accordance with any one of claims 1 to 4.

7. Method for producing an artificial neuron implementing integration, leakage and firing functions, **characterised in that** it comprises the following steps:

   - obtaining a material belonging to the family of the Mott insulators,
   - obtaining an artificial neuron of the "leaky integrate and fire" reference model composed of a single monocomponent electric dipole, by deposition of a layer of conductive material:

* at a first end of said Mott insulator material to form a first electrical electrode,
* at a second end of said Mott insulator material to form a second electrical electrode.

8. Production method according to claim 7, wherein said step of obtaining a material is carried out by cutting a Mott insulator crystal block, and wherein said step of depositing a layer of conductive material is carried out as a function of said cut crystal block.

9. Production method according to claim 7, wherein said step of obtaining a material is carried out by depositing a thin layer of a Mott insulator material on a substrate sheet, and wherein said step of depositing a layer of conductive material is carried out as a function of said deposited thin layer.

10. Production method according to claim 7, wherein said step of obtaining a material is carried out by depositing a nanotube based on a Mott insulator material on a substrate sheet, and wherein said step of depositing a layer of conductive material is carried out as a function of said deposited nanotube.

11. Production method according to claim 7, wherein said step of obtaining a material is carried out by depositing a nanowire based on a Mott insulator material on a substrate sheet, and wherein said step of depositing a layer of conductive material is carried out as a function of said deposited nanowire.

**Figure 1**

**Figure 2**

**30**

*31*

INPUT           OUTPUT

**32**          **33**

**Figure 3**

**40A**

**41A**

**42A**

INPUT          OUTPUT

**43A**

**44A**

**Figure 4A**

**40B**

**41B**

**42B**

INPUT          OUTPUT

**43B**

**44B**

**Figure 4B**

Figure 5A

Figure 5B

Figure 5C

Figure 6

S(t)

**Signal à
l'entrée du
neurone**

t

**Figure 7A**

$v(t)$

**Seuil**

*Fonctions:
"Intégration"
"Fuite"*

t

**Figure 7B**

**Signal à la
sortie du
neurone**

$S_{out}(t)$

*Fonction: "Tir"*

t

**Figure 7C**

Figure 8

Figure 9

Figure 10

**Figure 11**

$t_{ON} = 15 \ \mu s$
$t_{OFF} = 30 \ \mu s$

$N_{FIRE} = 6$

**Figure 12A**

$t_{ON} = 20 \ \mu s$
$t_{OFF} = 30 \ \mu s$

$N_{FIRE} = 4$

**Figure 12B**

$t_{ON} = 15 \ \mu s$
$t_{OFF} = 170 \ \mu s$

$N_{FIRE} = 8$

**Figure 12C**

**Figure 13A**

**Figure 13B**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20140035614 A

**Littérature non-brevet citée dans la description**

- **M. D. PICKETT et al.** A scalable neuristor built with Mott memristors. *NATURE MATERIALS,* 16 Décembre 2012, vol. 12 (2), 114-117